# EUROPEAN PATENT APPLICATION

(11) **EP 1 732 373 A2**
(43) Date of publication of application: **13.12.2006**
(21) Application number: 06011893.2
(22) Date of filing: 09.06.2006
(51) Int. Cl.: H05K 5/00

(54) **Housing for protection and connection of electrical or electronic components, particularly for household appliances**

(30) Priority: 09.06.2005 IT BL20050012
(71) Applicant: D.E.M. S.r.l., 32013 Longarone (BL) (IT)
(72) Inventor: de Marco, Doreano Pierino, Ing., 32010 Zoldo Alto (BL) (IT)
(74) Representative: Beszédes, Stephan G.

(57) **Abstract**

The subject-matter of the invention is a housing (10) for protecting and connecting electrical or electronic components, to be connected through said housing (10), which is to be fixed to a frame of an appliance, with an electrical circuit, wherein the housing (10) includes a hollow body having an opening (12) and enclosing a space (19), the opening (12) having a shape of a circular crown and being equipped with radial slits (17), into which radial teeth (38) are to be positioned, the teeth (38) being on a side surface (32) of a lid (30) which is accommodated in said space (19), the lid (30) having a shape and dimensions corresponding to the opening (12) and being equipped with through slits (35), into each of which a plug (40) is made locked, via a coupling, to whose inner end (41) the component to be protected is wired and whose outer end (42) is able to be coupled to an output of a wire of an electrical supply cable.

## Description

The present invention relates to a new constructive embodiment of a protective housing or container of electrical or electronic components, such as interference suppressing filters, which are to be connected through said housing to an electrical circuit, and the housing should be attachable to a supporting frame, particularly of household appliances in general.

One novel feature of the invention is to provide a closure lid of the container, also acting as a wiring of its inner component, which lid is pressure fitted onto a rim of said container to which it remains movably engaged by means of radial teeth receivable in corresponding spaces within the rim of the container. The lid can be further provided with locking inserts of the plugs or electrical connection members to an outer independent power supply cable, so as to sum additional efficiency to the solidity and safety of the connection of the protected inner component.

The correct functioning of a household appliance, beside the good quality of the main parts which specify it for its specific function, requires presence of particular electric and electronic components, such as thermostats, timers, capacitors, interference suppressing filters and other components which are suitable to make the use of said appliance more efficient. Such components have to be protected and insulated by means of a container which is attachable to a frame of the appliance and which is in connection with the electrical parts of the appliance, as proposed for example in the European Patents No. EP 0 293 325 or No. EP 0 836 257.

With the containers to which these exemplary patents relate, and in all cases of containers having similar components currently used and known, beside their mechanical attachment to the frame of the appliance, the problem also is to provide a good solidity of the electrical connection of the components with the remaining electrical portion of the appliance, so that an optional random traction of the electrical supply cable can not easily disconnect the component or generate serious problems of short circuit of the machine.

The current solutions to this problem are, nowadays, of two types: a more recent mechanical solution, which provides for the clamping of the end of the supply cable in a special notch or groove in a holding housing of the electrical or electronic component, and a previous physical solution which provides for the dipping of the cable end and of its electrical connection wires in a resin bath which, upon its following setting, incorporates the end of the supply cable and prevents it from coming out of the protection housing.

In this latter event, a preventive preparation of the wiring between the outer supply cable and inner component to be protected is required. Therefore a suitable amount of resin is inserted into the bottom of the container. Then the container is turned and an adequate time period is waited for till the resin is set which in this way drowns and locks the cable end to the container and to its inner component.

This technique exhibits a first serious drawback in that a small container for the component to be protected requires large storage and delivery overall dimensions, being already associated to a cable which, per se, could more advantageously be available also on the application location of the same component to be protected.

Another big drawback of this dipping technique of the cable end in a resin bath is given by the fact that, in the event of failure of the component, it is necessary to substitute the container with its entire cable, moreover with dispersion of the container and of its resin, resulting also in environmental pollution.

In order to solve these and other problems, a more recent technique allows elimination of the resin bath and formation of containers which, as stated above, are adapted to lock the end of the supply cable, trapping or clamping it in special grooves, as proposed for example by patents EP 0 805 617 and WO 03/088424.

However, also this technique has shown practical drawbacks. First of all, one has to fabricate containers comprising multiple members to be assembled, therefore having greater overall dimensions and a higher cost, compared to the previous ones.

Another drawback of this technique is given by the fact that the application of the cable and the optional substitution of the inner component to be protected can be carried out only with special complex equipment which, beside its cost, is not always available for the maintenance operator of the appliance to which said component is applied.

It is an object of the present invention to provide a protection housing for electrical or electronic components to be associated to an appliance system, particularly interference suppressing filters, wherein such a housing is equipped with a lid which is provided with suitable plugs for an electrical connection to be associated to an outlet of an outer independent (power) supply cable, wherein said lid can be firmly and movably coupled to a rim of said housing, i.e. a hollow holding body, without having to manufacture complex labyrinths or clamping grooves at the cable, and without having to dip the end of the cable and its wirings into a resin.

With regard to this object, another important object of the present invention is to facilitate the wiring operation of the wires of the cable to the inner component, such as that of electrical connection of the component to an independent electrical supply cable.

Another object of the invention is to allow in any moment the protected component and its wiring to be inspected and substituted.

Another object of the invention is to ensure the best coupling and attachment of the plugs, for example of the Faston type, to the lid of the housing, further contributing to the solidity of the connection between the electrical supply cable and the protected component.

The specified task and the other objects set forth above are, in effect, perfectly achieved by the present invention, which substantially comprises a hollow body and can be equipped with adequate aeration (vent) slits, to the port thereof a space is obtained under the shape of a circular crown equipped with a pawl, beside a series of radial slits, into which, subject to adequate pressure, notches or pawls are positioned being present on the circular side surface of a lid which is accommodated in said space, the lid being equipped with a series of inner pins, each having a through slit, in any one of which the sheet or plug, to which inner side the electrical or electronic component to be protected is wired, and which outer face normally can be coupled to an output of an electrical supply cable, the plug being accommodated and made practically slidable, therefore lockable, upon coupling.

A best and more complete understanding of the invention is given by the following disclosure of an embodiment thereof, which is given merely by way of example and non-limiting, also proposed with the aid of 10 schematic Figures, reproduced on 4 enclosed sheets and wherein:

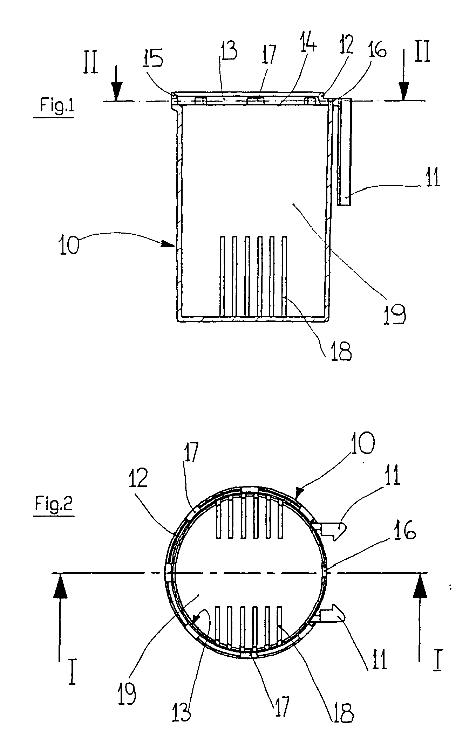

- Fig. 1 shows a vertical view of a protection housing or container for a electric or electronic component to be associated to a standard appliance, being shown according to the sectional plan I - I in Fig. 2;
- Fig. 2 shows a plan view of the container of Fig. 1, which is shown according to the sectional plan II - II of the Fig. 1;

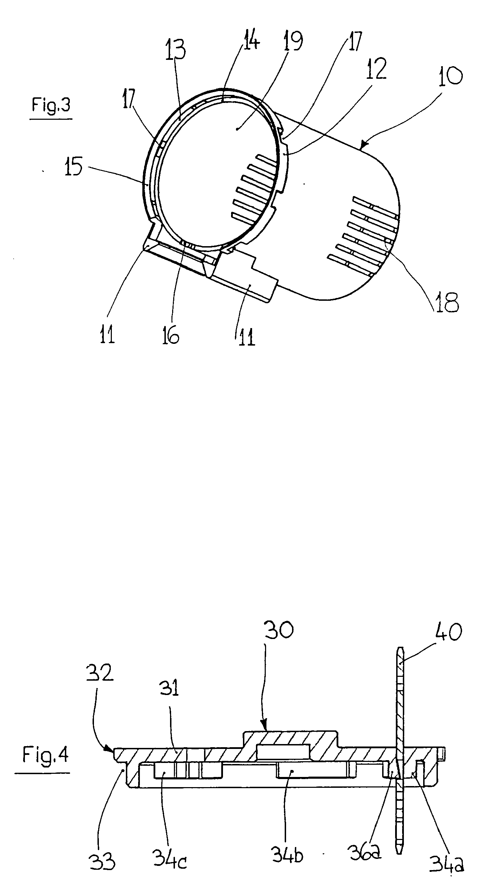

- Fig. 3 shows a perspective view of the container of Figs. 1 and 2;
- Fig. 4 shows a sectional view of a lid for being applied to the container of Fig. 1, the lid being enlarged, according to the sectional plan IV - IV of Fig. 5;
- Fig. 5 shows a plan view of the lid of Fig. 4;
- Fig. 6 shows a perspective view of an electrical connection plug or member to apply in the special seats of the lid of Fig. 5, such as represented operative on the lid of Fig. 4;
- Fig. 7 shows a perspective view of the plug of Fig. 6, upon an insertion step into one of the seats of the lid of Fig. 5;
- Fig. 8 shows a perspective view of the container of Fig. 1 which is already coupled to the lid of Figs. 4 and 5, which lid is already equipped with its connection plugs of Fig. 6, wherein the inner face of each plug is already wired to the electrical or electronic component to be protected;
- Fig. 9 shows a perspective view of a part to be coupled to an inner winding of the housing in Fig. 8.

In all the Figures like members are represented, or have to be considered as represented, by like reference numerals.

According to a constructive embodiment, proposed by way of example in the Figures, a container or housing 10, basically of a cylindrical and hollow shape, has overall dimensions not different from those of current containers having a supply cable assembled with resin, and which are generally smaller than the overall dimensions of current containers having the supply cable mechanically locked.

The container 10 has/can have a pair of guides 11 which are to be accommodated in suitable slides or seats already prearranged on an appliance frame (not shown), for the attachment thereof, according to an already known technique.

A base of the guides 11 is integral with a cylindrical outer surface of the container 10, and an upper end thereof marks the beginning and end of an edge 12, having the shape of a circular crown, which is integral with a rim 14 of the outer surface of the container 10, and which provides an inner recess 13, this recess 13 always having the shape of a circular crown being concentring and defined by the upper rim 14 of the cylindrical container 10 and by its upper rim 15, preferably equipped with upper inner chamfering or grooving.

The intermediate length of the rim 14 of the container 10, which is included between the two guides 11, has a rise or tooth 16, while along the groove or recess 13 through holes or slits 17 are obtained radially which are preferably equidistant to each other.

A series of milling or openings 18 allows to lighten the container 10 and allows a possibility of aeration (vent) of its inner space 19.

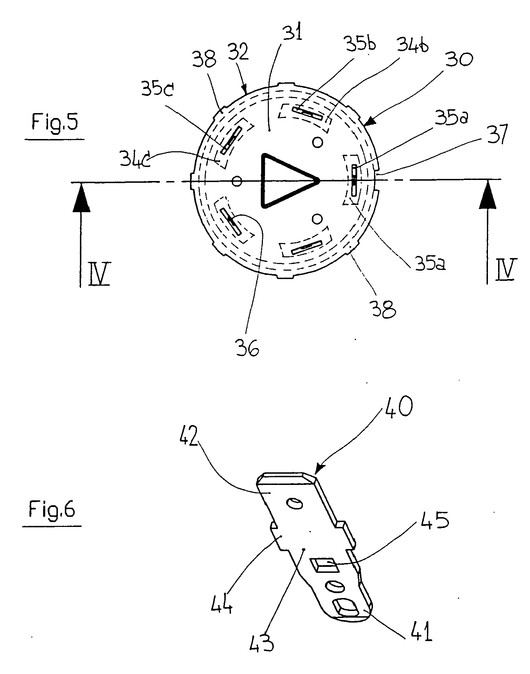

With reference to Figs. 4 and 5, as already specified, a lid 30 is illustrated which is adapted to be accommodated within the groove 13 of the edge 12 of the container 10, in order to support and wire the electrical and electronic inner component which needs protection, beside allowing its connection to the outer electrical supply cable.

The lid 30 basically consists of a disk 31 having a circular outer surface 32 with a diameter equal to the diameter of the groove 13 of the container 10, into which groove 13 the disk is intended to be accommodated.

The disk 31 is then equipped with a lower shoulder 33, having an outer diameter basically equal to the inner diameter of the rim 14 of the container 10, in which it is intended to be accommodated.

The inner surface of the disk 31, which is equipped with the shoulder 33, has also a series of pins 34a, 34b, 34c, etc., each having its through slit 35a, 35b, 35c, etc., such as exemplified in Fig. 5.

Each slit 35a, 35b, 35c, etc., has then its central wall 36a, 36b, 36c, etc. with reduced and sloped section, such as shown in Fig. 4 and a function of which is described in more detail herein below.

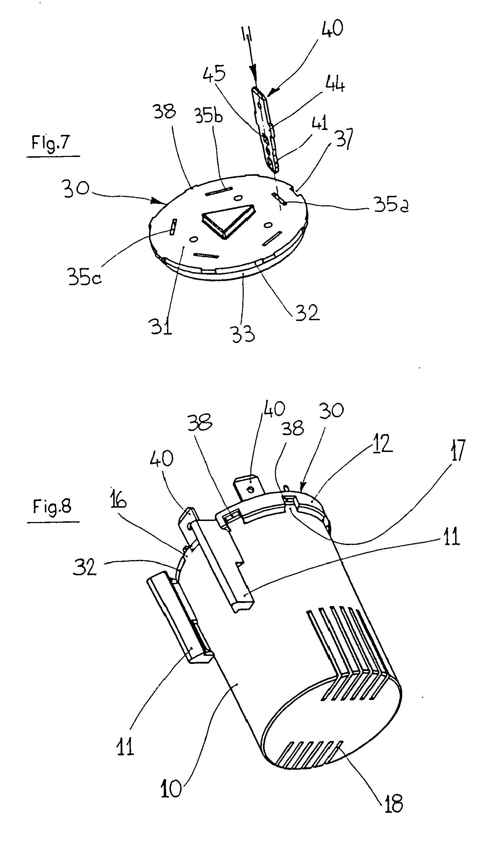

As also shown in Fig. 7, each slit 35 is adapted to receive a plug 40, for example a Faston type plug, as represented in Fig. 6, which is pressure fit into the slit, according to the direction indicated in Fig. 7, until reaching a preestablished position.

Regardless of the type of plug 40 to be fitted, which will be a function of the type of connection provided for the supply and wiring cable with the inner member to be protected, each plug 40 is equipped with an inner end 41 and an outer end 42.

An intermediate portion 43 is preferably equipped with at least a tongue 44, projecting sideways (laterally) from the body of the plug 40 and being adapted to meet a bottom of the disk 31 of the lid 30, in order to define a stop for insertion of the plugs 40 into the various slits 35 of the lid 30, beginning from its outer surface.

The intermediate region 43 can be equipped with a wide through hole 45, for example of square or rectangular shape, which is suitable to accommodate a head (tab) of the sloped wall 36 of the lid 30, in order to prevent inadvertent withdrawals of the plug 40, if this has been positioned in its own seat 35.

The outer circular surface 32 of the disk 31 has a recessed notch 37 and a series of radial teeth 38, which are distributed so as to be respectively received by the pawl or tooth 16 and in the slits 17 of the circular space 13 overhanging the rim 14 of the container 10.

Having thus described the main parts of the development, a summary of their functioning and their compliance with the object described is given herein below, with particular reference to Figs. 7 and 8.

A series of plugs 40 is applied to the slits 35 of the lid 30, fitting (inserting) the inner end 41 thereof into the outer surface of the disk 31.

The fitting step of the plugs 40 is completed when their tongues 44 abut against the outer surface of the lid 30.

At the same time, the sloped wall or tab 36 of each slit 35, initially pressed by the solid portion of the end 41 of each plug 40, meets the slit 45 and then is inserted into it, abutting against its bottom, preventing the plug 40 from any possibility of being withdrawn, thus ensuring maximum stability, in co-operation with the tongues 44 thereof, against any possibilities of being withdrawn, even in the event of unexpected tearing or impacts, according to one of the objects set forth.

The application of the plugs 40, with the number and in the expected positions according to the needs of the inner member to be guarded, is preferably prearranged by the manufacturer, who is thus giving the container 10 into the market, which is generally suitable for any protections, wherein the lid 30 is preventively equipped with the desired number and type of plugs 40.

First, the user provides, for the wiring of the inner ends 41 of each plug 40, a lid 30 of the selected type, with the electrical or electronic component to be protected. Then he/she combines the lid 30 with the container 10, which, in turn, must/can be fixed to the frame of the appliance to be completed.

The user then brings the notch 37 of the lid 30 in the proximity of the tooth 16 of the rim 14 of the container 10, thereby fitting said tooth 16 in the same notch 37.

Then, he/she can proceed to apply an adequate pressure on the outer surface of the disk 31 of the lid 30, so as to force the teeth 38 to slide on the chamfering of the upper rim 15 of the edge 12 and to fit into the respective holes 17 of the circular crown space 13, into which the circular rim 32 of the lid 30 is thus brought.

As an effect of the holding of the teeth 38 into the seats 17 and of the same circular rim 32 within the space 13, the lid 30 remains fitted on the rim 14 of the container 10, allowing for the desired protection of the electrical component previously attached to the inner portion thereof.

Of course, if the need arises to substitute or restore the inner component, it is sufficient to apply some amount of pressure on the notches 17 of the edge 12, for example with a screwdriver, in the proximity of its coupling with the teeth 38, such as to allow the disengagement thereof, thereby allowing to open the lid 30 and therefore to restore or substitute the component.

In the end, the user connects each plug 40 to the respective wire of the outer electrical supply cable or the other outer devices to be connected to the inner component of the housing 10, for example with a series of outlets of a corresponding Faston type.

It is thus provided a container 10 having minimal overall dimensions which is equipped with plugs 40 for a connection to the outer supply cable, applied to its lid 30, which can be fixedly and releasably coupled to the rim 14 of the container 10, without the need to generate locking grooves or labyrinths of the same cable, and without the need of a preventive dipping thereof into polymerized resins.

The container 10 can be assembled easily, besides being of an easy connection with the supply cable.

The container 10 ensures the possibility of being inspected and allows maintenance and substitution of the electrical or electronic component contained and protected therein, besides being safe and stable.

A winding is therefore fixed to the lid 30 and to its plugs 40 which is protected by the lid 10, but which is not attested against it, staying projecting on the same lid 30.

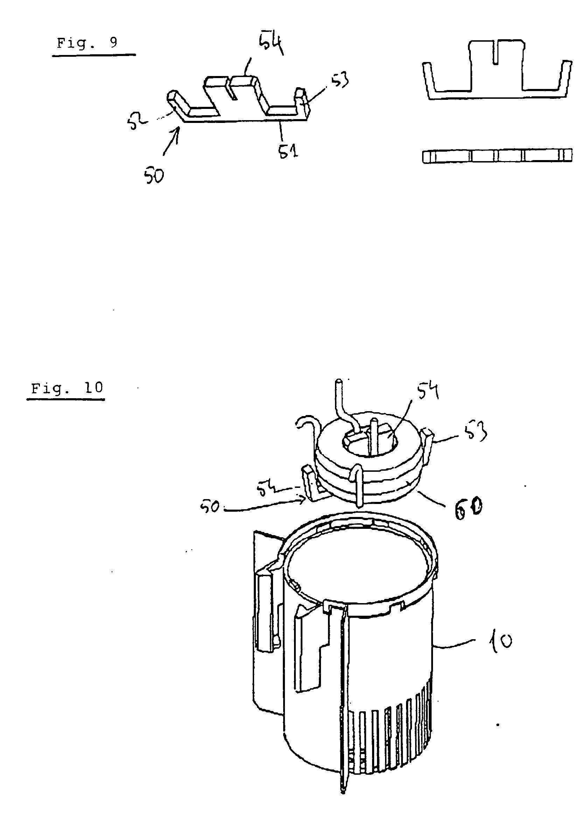

With reference to Figs. 9 and 10, in order to avoid that winding from being damaged, due to the continuous possible vibrations of the appliance to which it is applied to a projecting base 60 of the winding, a comb 50 is applied which basically consists of a base 51 having two side pawls 52 and 53 and a central stretch body 54, the body 54 being accommodated in an axial recess of the winding, while the side pawls 52 and 53 abut against the cylindrical inner surface of the housing 10.

In this way, the base 60 of the winding inside the housing 10 is no more projecting, but supported by said comb 50.

Of course, the constructive solution disclosed and illustrated herein is to be considered, as stated before, merely illustrative and non-limiting, since it may be carried out also with other constructive embodiments.

As an example, the possibility to apply any type or number of plugs 40 is indicated, preferably always equipped with a central portion 43 with tongues 44 and slit 45 for locking to the lid 30, as well as there may be a variable number of **teeth 38 and their seats 17, beside la possibility to reverse** their locking positions between edge 12 and side surface 32 of the lid 30.

These and similar modifications or adaptations, however, are to be considered to fall within the scope of protection as defined by the appended claims.

## Claims

1. Housing (10) for protecting and connecting electrical or electronic components such as interference suppressing filters, which are particularly used with a household appliance, the components are to be connected through said housing (10), which is to be fixed to a supporting frame of the appliance, with an electrical circuit, wherein the housing (10) includes a hollow body having an opening (12) and enclosing a space (19), the opening (12) having a shape of a circular crown and being equipped with a series of radial or peripheral slits (17), into which, under an adequate pressure, radial teeth (38) are to be positioned, the radial teeth (38) being present on a side surface (32) of a lid (30) which is accommodated in said space (19), the lid (30) having a shape and dimensions basically corresponding to the opening (12) and being equipped with a series of crosswise through slits (35), into each of which a plug (40) is accommodated and made locked, via a coupling, to whose inner end (41) the component to be protected is wired and whose outer end (42) is normally able to be coupled to an output of a wire of an electrical supply cable or to another portion of the appliance.

2. Housing according to claim 1, wherein the housing is a container (10) which is made fixedly and releasably coupled to the lid (30), said lid (30) being equipped with slits (35), crosswise to its thickness (31), into which slits (35), plugs (40) are insertable and lockable, each plug (40) having an inner end (41) which is available for wiring of the electric or electronic component to be protected, while an outer end (42) is shaped, for example having a Faston shape, for connection with the output of the supply cable or with another outer component.

3. Housing according to claim 2, wherein the container (10) has a rim (14), the container (10) being adapted to form a space (13) having an edge (12) positioned outside the container (10) and having an upper rim 15 which extends circumferentially around a rim (14), except for a length which is preferably included between two ends of guides 11.

4. Housing according to claim 3, wherein the rim (14) of the container (10) has at least a tooth (16) which is adapted to receive a notch (36) of the lid (30) which is to be coupled to said container (10), said tooth (16) being preferably positioned between the ends of the guides (11) for the coupling of the container (10) to the appliance frame.

5. Housing according to claim 3, wherein the space (13) has preferably a crop end shape of circular crown and is equipped with a series of radial slits or through ports (17), each of which is adapted to accommodate a radial tooth (38) which is present on the circular rim (32) of the lid (30).

6. Housing according to claim 5, wherein the radial teeth (38) and the notch (37) can be inversely manufactured on the upper rim (15) of the container (10), to be associated to opposing notches and teeth (16, 17) to be manufactured on the side surface (32) of the lid (30).

7. Housing according to one of claims 1 to 6, wherein the upper rim (15) of the edge (12), which is integral with the rim (14) of the container (10), is equipped with an inner chamfering or grooving, in order to promote the crossing and the accommodation of the side surface (32) and its teeth (38) within the space (13) and the slits (17), respectively.

8. Housing according to claim 2, wherein the plug (40), to be fitted in the crosswise slits (35) of the lid (30) has a central portion (43) equipped with at least a tongue (44) and a slit (45).

9. Housing according to claim 2, wherein the crosswise slits (35) have a central portion or tab (36) which has a reduced section and a sloped surface.

10. Housing according to claims 7 to 9, wherein inserting the plug (40) into the respective crosswise slit (35) of the lid (30) is defined and made stable and safe by the co-operation between the stop consisting of the tongues (44) against the outer surface of the lid (30) and the coupling of the tab (36) on the lower base of the hole (45) of the same plug (40).

11. Housing according to one of claims 1 to 10, wherein a comb (50) is applied to a projecting end (60) of an inner winding of the housing (10) which is integral with the lid (30) and the plugs (40), for the abutment of the end (60) to inner walls of the housing (10).

12. Housing (10) for protecting and connecting an electrical or electronic component which is particularly to be used with a household appliance, the housing (10) comprising a container (10) and a lid (30) which are connectable to each other to define an inner space (13) for accommodating the component, wherein the container (10) has an edge (12), the edge (12) defining an opening which can be closed by the lid (30), and being a circular crown, the crown having a plurality of radial through holes (17), wherein the lid (30) includes a closing member (31), particularly a disk (31), having an outer lateral surface (32) which fits into the opening and has radial extending teeth (38) for engaging in the radial through holes (17) in a closed state of the housing (10), the closing member (31) having through slits (35) for respectively receiving a plug (40) for electrically connecting the inside component to an outside of the housing (10).

13. Housing according to claim 12, wherein the closing member (31) is substantially circular.

14. Housing according to claims 12 or 13, wherein the crown has a step-shaped cross section and the closing member (31) has a circumferentially lower shoulder (33) such that the lid (30) fits into the crown-shaped opening of the container (10).

15. Housing according to one of claims 12 to 14, wherein the through slits (35) substantially extend in an axial direction.

16. Housing according to one of claims 12 to 15, wherein each of the through slits (35) comprises a pin (35a, 35b, 35c) and a central wall (36a, 36b, 36c) which substantially extend along the axial direction.

17. Housing according to claim 16, wherein each central wall (36) has a sloped and reduced section in order to form a tab (36) which can engage into a through hole (45) of the plug for preventing inadvertent withdrawals of the plug (40) when the plug is inserted into one of the through slits (35).

18. Housing according to claim 17, wherein the plug (40) has an inner end portion (41) for facing the space (13), an outer end portion (42) for protruding from the closing member (31), and an intermediate portion (43), the intermediate portion including the through hole (45) for receiving the tab (36) and preferably at least one tongue (44) for abutting against the closing member (31) when the plug (40) is inserted into one of the through slits (35) with its inner end portion (41) first.

19. Housing according to claim 18, wherein the intermediate portion (43) is arranged such that the through hole (45) thereof faces the tab (36) when the plug (46) is inserted.
